# DEMANDE DE BREVET EUROPEEN

(11) **EP 4 465 299 A1**
(43) Date de publication de la demande: **20.11.2024**
(21) Numéro de dépôt: 24174247.7
(22) Date de dépôt: 06.05.2024
(51) Int. Cl.: G11C 13/00

(54) **DISPOSITIF DE MÉMOIRE DU TYPE À CHANGEMENT DE PHASE ET PROCÉDÉ DE LECTURE D'UN TEL DISPOSITIF**

(30) Priorité: 19.05.2023 FR 2304986
(71) Demandeur: STMicroelectronics International N.V., 1228 Plan-les-Ouates, Geneva (CH)
(72) Inventeur: LECOQ, Xavier, 38500 VOIRON (FR); RAZAFINDRAIBE, Alin, 38400 SAINT MARTIN D'HERES (FR); FOREL, Christophe, 38120 SAINT EGREVE (FR)
(74) Mandataire: Casalonga

(57) **Abrégé**

Une cellule-mémoire à changement de phase à lire (CEL) est associée à une cellule-mémoire de référence à changement de phase (CELR) placée dans un état initialisé, la cellule-mémoire de référence étant placée à côté de la cellule-mémoire et ayant une structure identique à celle de la cellule-mémoire. On applique une première tension sur la cellule-mémoire et on fait délivrer un premier courant par la cellule-mémoire. On applique une deuxième tension sur la cellule-mémoire de référence et on fait délivrer un deuxième courant par la cellule-mémoire de référence. Un amplificateur de lecture (AMP) est couplé à la cellule-mémoire et à la cellule-mémoire de référence et est configuré pour délivrer une information représentative de la valeur logique de la donnée en fonction des valeurs respectives du premier courant et du deuxième courant.

## Description

L'invention concerne les mémoires non volatiles, plus précisément les mémoires à changement de phase (ou PCM : Phase Change Memory) et plus particulièrement la lecture de telles mémoires.

Les mémoires à changement de phase sont des mémoires non volatiles s'appuyant sur les propriétés des matériaux à changement de phase.

Un matériau à changement de phase a, en effet, la capacité de basculer d'un état faiblement résistif à un état résistif grâce à son échauffement.

Les mémoires à changement de phase tirent profit du fait que les résistances électriques des différents états des matériaux à changement de phase sont différentes afin de stocker des données.

Plus précisément, le matériau à changement de phase a la capacité de basculer d'un état résistif (HRS, High Résistif State) à un état faiblement résistif (LRS, Low Résistif State) sous l'effet de la chaleur et de l'effet Joule généré par l'application d'un courant entre des électrodes.

Le basculement d'un état résistif à un état faiblement résistif correspond à une opération de programmation ou d'activation dite « SET » c'est-à-dire une opération d'écriture d'une valeur de donnée binaire, par exemple d'une valeur logique 1.

La mémoire est alors dans un état dit « initialisé » (SET).

Le basculement d'un état faiblement résistif à l'état résistif correspond à une opération d'effacement ou de désactivation dite « RESET », c'est-à-dire une opération d'écriture d'une valeur de donnée binaire opposée, par exemple d'une valeur logique 0.

La mémoire est alors dans un état dit « réinitialisé » (RESET).

Pour effectuer une opération de programmation ou SET, le matériau à changement de phase est chauffé entre ses températures de cristallisation et de fusion puis refroidi lentement afin d'obtenir une phase cristalline. L'impulsion de courant présente donc une décroissance lente.

Par contre, pour rendre le matériau à changement de phase amorphe (opération d'effacement ou RESET) il est chauffé au-dessus de sa température de fusion puis refroidi rapidement afin de figer à l'état amorphe à température ambiante. L'impulsion de courant est donc très courte et abrupte.

Le courant de lecture d'une mémoire à changement de phase est hautement variable et dépend
a) du procédé de fabrication de la mémoire (P : Process),
b) de la température (T),
c) des chutes de tension (V) sur les lignes de mots,
d) du cyclage et du vieillissement de la mémoire ainsi que
e) des pertes résistives capacitives des chemins d'interconnexion entre les différents éléments de la mémoire, et enfin
f) des chutes de tension (V) sur les lignes de bits.

Pour pallier à ces variations de courant de lecture liées aux points a), b), c), d), et f) ci-dessus, la lecture est faite dans un mode dit à entrée unique (« single-ended mode » en anglais) en comparant le courant tiré par la cellule-mémoire avec une source de courant et en utilisant des réglages très relâchés pour vérifier les résultats de programmation et d'effacement.

Cependant, une telle solution est sensible aux dérives de la résistance de la mémoire et aux décalages (offset) structuraux observés entre une cellule-mémoire et une source de courant.

Une autre solution de l'art antérieur consiste à effectuer une lecture en mode différentiel entre la cellule-mémoire et une cellule-mémoire complémentaire (c'est-à-dire stockant une donnée logique opposée à la donnée stockée dans la cellule-mémoire) de façon à obtenir des lectures rapides dans toutes les conditions PVT (Process, Tension, Température) avec des fortes différences de courant.

Cependant, une telle solution est très coûteuse en encombrement sur silicium puisque toutes les cellules-mémoires sont « multipliées par deux » en raison de la présence des cellules mémoires complémentaires.

Il existe donc un besoin de proposer une solution de lecture d'une mémoire à changement de phase qui soit fiable quelles que soient les conditions PVT.

Il existe également un besoin de proposer une solution qui soit également économe en encombrement surfacique sur silicium.

Selon un mode de réalisation il est proposé d'effectuer une lecture de la cellule-mémoire dans un mode à entrée unique (single ended) et d'utiliser à la place de la source de courant de l'art antérieur, une cellule-mémoire de référence structurellement identique à la cellule-mémoire à lire, et placée dans un état initialisé (SET).

Selon un autre mode de réalisation il est proposé d'associer une cellule-mémoire de référence par groupe de plusieurs cellules-mémoires à lire, ce qui offre un gain de place appréciable sur silicium.

Selon un aspect, il est proposé un dispositif de mémoire du type à changement phase (PCM).

Ce dispositif de mémoire comprend (dans une architecture minimale) :
- une cellule-mémoire à changement de phase configurée pour avoir un état initialisé ou un état réinitialisé correspondant respectivement à deux valeurs logiques d'une donnée stockée dans la cellule-mémoire et à deux valeurs de référence correspondantes de courants (par exemple une valeur de référence inférieure à 1 microampère et une valeur de référence de l'ordre de 16 microampères) délivrés par la cellule-mémoire, et
- une cellule-mémoire de référence à changement de phase placée dans un état initialisé, la cellule-mémoire de référence étant placée à côté de la cellule-mémoire et ayant une structure identique à celle de la cellule-mémoire,
- des moyens de lecture configurés pour lire la donnée stockée et comportant
   --des premiers moyens configurés pour appliquer une première tension sur la cellule-mémoire et faire délivrer un premier courant par la cellule-mémoire,
   --des deuxièmes moyens configurés pour appliquer une

deuxième tension sur la cellule-mémoire de référence et faire délivrer un deuxième courant par la cellule-mémoire de référence dont la valeur est comprise entre lesdites deux valeurs de référence, -un amplificateur de lecture possédant une première entrée couplée à la cellule-mémoire et une deuxième entrée couplée à la cellule-mémoire de référence et configuré pour délivrer une information représentative de la valeur logique de la donnée en fonction des valeurs respectives du premier courant et du deuxième courant.

Cette lecture à mode en entrée unique utilisant une telle cellule-mémoire de référence est plus précise comparée à la méthode de lecture à entrée unique classique utilisant une source de courant car :
- elle est moins sensible au décalage de résistance de la cellule-mémoire PCM et aux décalages structuraux observés entre une cellule-mémoire PCM et une source de courant, et
- les courants de lecture de la cellule-mémoire et de la cellule-mémoire de référence ont une variabilité moindre vis-à-vis de la température et de la tension.

Selon un mode de réalisation, la valeur du deuxième courant est égale à la moitié de la différence entre les deux valeurs de référence.

Selon un mode de réalisation, la distance entre la cellule-mémoire et la cellule-mémoire de référence est comprise entre 10 micromètres et 20 micromètres.

Selon un mode de réalisation, le dispositif comprend en outre des moyens de rafraîchissement configurés pour replacer régulièrement la cellule-mémoire de référence dans son état initialisé.

Selon un mode de réalisation, les moyens de rafraîchissement comprennent un générateur de courant configuré pour délivrer une impulsion de courant à la cellule-mémoire de référence de façon à la placer dans son état initialisé et des moyens de vérification de l'état initialisé de la cellule mémoire de référence incluant l'amplificateur de lecture.

En pratique le plan mémoire du dispositif de mémoire comporte plusieurs cellules mémoires.

Dans ce cas et selon un mode de réalisation, le dispositif comprend au moins un groupe de plusieurs cellules-mémoires associées à la cellule-mémoire de référence, respectivement couplées à la première entrée de l'amplificateur de lecture par l'intermédiaire d'interrupteurs commandables, et des moyens de commande configurés pour sélectionner successivement lesdits interrupteurs de façon que les moyens de lecture puissent lire successivement chaque cellule-mémoire dudit au moins un groupe.

Par exemple, le dispositif comporte au moins un groupe de N cellules-mémoires, N étant un nombre pair, partitionné en deux sous-groupes de N/2 cellules-mémoires, et une cellule-mémoire de référence par groupe encadrée par les deux sous-groupes de cellules-mémoires.

Selon un autre aspect, il est proposé un procédé de lecture d'un dispositif de mémoire du type à changement phase, le dispositif comprenant une cellule-mémoire à changement de phase configurée pour avoir un état initialisé ou un état réinitialisé correspondant respectivement à deux valeurs logiques d'une donnée stockée dans la cellule-mémoire et à deux valeurs de référence correspondantes de courants délivrés par la cellule-mémoire, procédé dans lequel
- on place une cellule-mémoire de référence à changement de phase dans un état initialisé à côté de la cellule-mémoire et ayant une structure identique à celle de la cellule-mémoire,
- on applique une première tension sur la cellule-mémoire pour lui faire délivrer un premier courant,
- on applique une deuxième tension sur la cellule-mémoire de référence pour lui faire délivrer un deuxième courant dont la valeur est comprise entre lesdites deux valeurs de référence,
- on compare la valeur du premier courant et la valeur du deuxième courant et on délivre une information représentative de la valeur logique de la donnée en fonction des valeurs respectives du premier courant et du deuxième courant.

Selon un mode de mise en oeuvre, la valeur du deuxième courant est égale à la moitié de la différence entre les deux valeurs de référence.

Selon un mode de mise en oeuvre, on place la cellule-mémoire de référence à une distance de la cellule-mémoire comprise entre 10 micromètres et 20 micromètres.

Selon un mode de mise en oeuvre, le procédé comprend en outre un rafraîchissement régulier de la cellule-mémoire de référence pour la replacer dans son état initialisé.

Selon un mode de mise en oeuvre, le rafraîchissement comprend une délivrance d'une impulsion de courant à la cellule-mémoire de référence de façon à la placer dans son état initialisé et une vérification de l'état initialisé de la cellule mémoire de référence.

Selon un mode de mise en oeuvre, on associe une cellule-mémoire de référence à plusieurs cellules-mémoires et on lit successivement chaque cellule-mémoire en utilisant la cellule-mémoire de référence.

Selon un mode de mise en oeuvre, on associe une cellule-mémoire de référence à un groupe de N cellules-mémoires, N étant un nombre pair, partitionné en deux sous-groupes de N/2 cellules-mémoires, et on place la cellule-mémoire de référence entre les deux sous-groupes de cellules-mémoires.

D'autres avantages et caractéristiques de l'invention apparaîtront à l'examen de la description détaillée de modes de mise en oeuvre et de réalisation nullement limitatifs, et des dessins annexés sur lesquels :
- [Fig. 1],
- [Fig. 2],
- [Fig. 3],
- [Fig. 4],
- [Fig. 5],
- [Fig. 6],
- [Fig. 7],
illustrent schématiquement des modes de mise en oeuvre et de réalisation de l'invention.

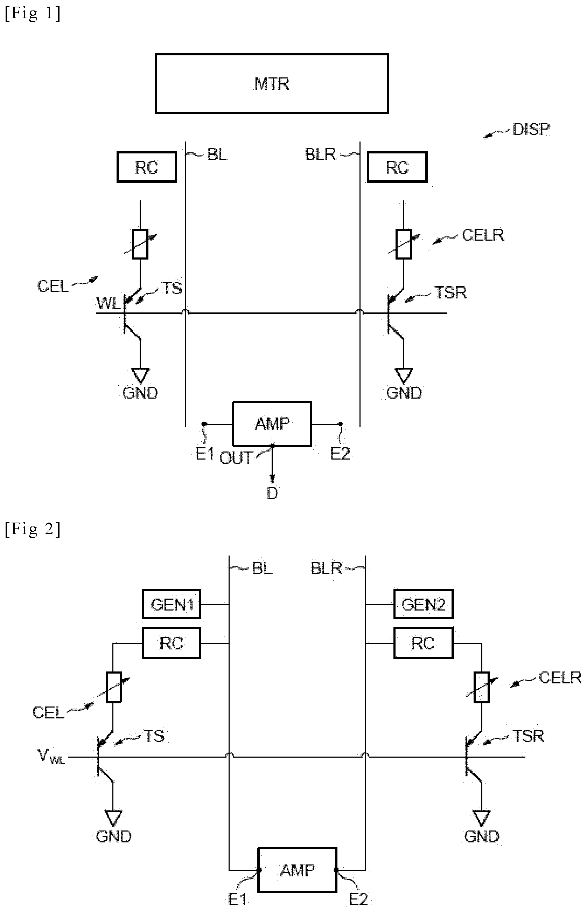

Sur la figure 1, la référence DISP désigne un dispositif de mémoire du type à changement de phase comprenant ici une cellule-mémoire à changement de phase CEL et une cellule-mémoire de référence à changement de phase CELR.

La cellule-mémoire CEL et la cellule-mémoire de référence CELR ont une structure identique et sont placées côte à côte.

La structure d'une cellule-mémoire à changement de phase est classique et connue en soi.

Plus précisément, elle comporte un élément mémoire par exemple comportant du germanium, de l'antimoine et du tellure qui présentent des valeurs de résistance différentes en fonction de l'état réinitialisé / initialisé (RESET / SET) de la mémoire.

Cet élément mémoire est associé à un dispositif de chauffage, par exemple deux électrodes, qui lorsqu'il est parcouru par un courant chauffe l'élément de mémoire par effet joule pour faire varier sa résistance.

La cellule-mémoire CEL est associée à un transistor de sélection TS qui est ici un transistor bipolaire PNP connecté en série entre l'élément de mémoire et un point froid d'alimentation, typiquement la masse GND.

La base du transistor bipolaire est connectée sur une ligne de mots WL et est destinée à recevoir une tension rendant passant ce transistor de façon à permettre la circulation du courant dans le dispositif de chauffage de façon à chauffer l'élément de mémoire.

La base du transistor bipolaire de sélection TSR associé à la cellule-mémoire de référence CELR est également reliée à la ligne de mots WL.

Bien entendu, les transistors bipolaires TS et TSR pourraient être remplacés par des transistors MOS, par exemple des transistors PMOS.

Une cellule-mémoire CEL dans un état initialisé (SET) est destinée à délivrer en lecture un premier courant de l'ordre de 16 microampères.

Une cellule-mémoire CEL dans son état réinitialisé (RESET) est susceptible de délivrer un premier courant inférieur à un microampère.

Ces courants sont obtenus en présence d'une tension appliquée sur l'élément de mémoire comprise entre 1,5 et 1,8 volts pour un transistor de sélection TS bipolaire et comprise entre 0,4 et 0,5 volt pour un transistor de sélection du type MOS.

Le dispositif de mémoire DISP comporte également une ligne de bits BL associée à la cellule-mémoire CEL et une ligne de bits BRL associée à la cellule-mémoire de référence CELR.

La référence RC désigne les résistances et capacités parasites résultant des interconnexions entre les différents éléments du dispositif DISP.

Le dispositif DISP comporte également un amplificateur de lecture AMP, de structure classique et connue en soi, possédant une première entrée E1 et une deuxième entrée E2 destinées à recevoir deux courants lors de la lecture de la cellule mémoire CEL et à délivrer sur la borne de sortie OUT une information représentative d'une donnée D ayant soit la valeur logique 0 soit la valeur logique 1.

Enfin, le dispositif DISP comporte des moyens de traitement MTR incorporant des moyens de lecture et des moyens de rafraîchissement dont on reviendra plus en détail ci-après.

Les interconnexions entre les différents éléments illustrés sur la figure 1 n'ont volontairement pas été représentés pour éviter d'alourdir la figure 1. En effet, selon les différentes configurations (lecture de la cellule-mémoire CEL, rafraîchissement de la cellule-mémoire de référence CELR), les connexions entre certains au moins de ces éléments sont différentes.

Ces connexions seront représentées sur les figures suivantes en fonction de l'opération envisagée.

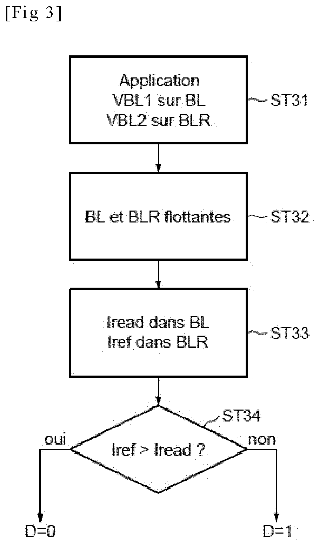

On se réfère maintenant plus particulièrement à la figure 2 et à la figure 3 pour décrire un mode de mise en oeuvre d'une lecture de la cellule-mémoire CEL.

Les moyens de traitement MTR de la figure 1 comportent ici des moyens de lecture incluant un premier générateur de tension GEN1 et un deuxième générateur de tension GEN2 destinés à être connectés respectivement aux lignes de bits BL et BLR.

Par ailleurs, les lignes de bits BL et BLR sont respectivement connectées aux deux entrées E1 et E2 de l'amplificateur de lecture AMP.

La cellule-mémoire CEL est connectée à la ligne de bits BL tandis que la cellule de référence CELR est connectée à la ligne de bits BLR.

La cellule de référence CELR est quant à elle placée dans son état initialisé (SET), par exemple à l'issue de la fabrication du dispositif de mémoire.

La lecture de la cellule CEL est décrite en référence à la figure 3.

Dans une étape ST31, on applique tout d'abord une tension VBL1 sur la ligne de bits BL et une tension VBL2 sur la ligne de bits BLR.

Ces deux tensions VBL1 et VBL2 sont respectivement délivrées par les deux générateurs de courant GEN1 et GEN2.

La tension VBL1 est celle qui permet d'obtenir un courant correspondant à l'état initialisé de la cellule-mémoire CEL (typiquement 16 microampères).

Pour un transistor de sélection bipolaire on choisira une tension VBL1 comprise entre 1,5V et 1,8V.

La tension VBL2 est une tension inférieure à la tension VBL1, de façon à faire délivrer à la cellule-mémoire de référence CELR un courant de référence se situant entre un courant de lecture (typiquement inférieur ou égal à 1 microampère) correspondant à l'état réinitialisé de la cellule-mémoire CEL et un courant de lecture (typiquement de l'ordre de 16 microampères) correspondant à l'état initialisé de la cellule-mémoire CEL.

Par exemple, on prendra une valeur de courant de référence égale à la moitié de la différence entre les deux courants précités, par exemple 8 microampères et dans ce cas la tension VBL2 pourra être typiquement de l'ordre de 100 à 200 millivolts de moins que la tension VBL1.

Bien entendu cette fourchette de 100 à 200 millivolts n'est qu'un exemple et l'homme du métier saura ajuster ces valeurs en fonction du courant de lecture, du type de transistor de sélection et des caractéristiques résistives/capacitives parasites des interconnexions entre les différents éléments du dispositif DISP.

Une fois que les lignes de bits BL et BLR ont été polarisées avec des tensions VBL1 et VBL2 dans l'étape ST31, on rend les lignes de bits BL et BLR flottantes (étape ST32) par exemple en déconnectant les deux générateurs GEN1 et GEN2 des lignes de bits BL et BLR ou bien en les stoppant.

Les transistors TS et TSR étant passants, la cellule-mémoire CEL tire un premier courant Iread qui circule dans la ligne de bits BL tandis que la cellule-mémoire de référence CELR tire un deuxième courant Iref qui circule dans la ligne de bit BLR (étape ST33).

Ces deux courants Iref et Iread sont comparés (étape ST34) dans l'amplificateur de lecture AMP.

Si le courant Iref est supérieur au courant Iread alors la donnée stockée dans la cellule-mémoire CEL correspond à un 0 logique (état RESET de la cellule CEL).

Si le courant Iread est supérieur au courant Iref, alors la donnée stockée dans la cellule-mémoire CEL correspond à 1 logique (état initialisé SET de la cellule CEL).

Cette lecture à mode en entrée unique est plus précise comparée à la méthode de lecture à entrée unique classique utilisant une source de courant car elle est moins sensible au décalage de résistance de la cellule-mémoire PCM et aux décalages structuraux observés entre une cellule-mémoire et une source de courant.

Par ailleurs, le fait que la cellule-mémoire CEL et la cellule-mémoire de référence soient placées côte à côte permet que les tensions appliquées sur les bases de transistor de sélection TS et TSR soient sensiblement les mêmes et que les chemins de lecture de la cellule-mémoire CEL et les chemins de lecture de la cellule-mémoire de référence CELR soient correctement équilibrés.

A titre indicatif, on pourra choisir avantageusement une distance comprise entre 10 micromètres et 20 micromètres séparant la cellule-mémoire CEL et la cellule-mémoire de référence CELR pour une technologie 18 nanomètres.

Bien entendu cette valeur de distance n'est qu'un exemple et l'homme du métier saura ajuster cette valeur, si nécessaire, en fonction notamment des caractéristiques des cellules-mémoires, des schémas de lecture et plus généralement de l'application envisagée.

La cellule-mémoire de référence peut dans certains cas perdre progressivement son état initialisé.

Il est donc avantageux, dans certaines applications, de pouvoir rafraîchir cette cellule-mémoire de référence pour la replacer régulièrement dans son état initialisé.

La fréquence de rafraîchissement dépend de l'application envisagée.

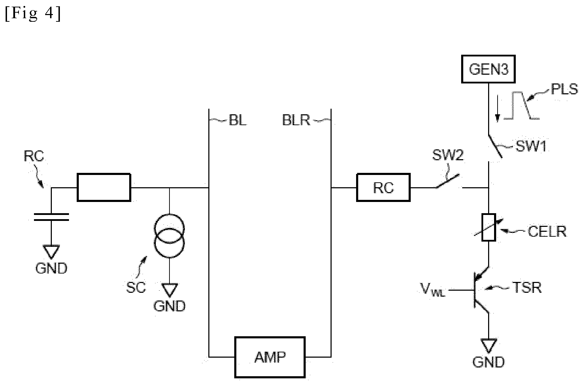

A cet égard, si l'on se réfère maintenant plus particulièrement à la figure 4, on voit que le dispositif comporte en outre des moyens de rafraîchissement configurés pour replacer régulièrement la cellule-mémoire de référence CELR dans son état initialisé.

Ces moyens de rafraîchissement comprennent ici un générateur de courant GEN3 configuré pour délivrer une impulsion de courant PLS (impulsion de programmation) à la cellule-mémoire de référence CELR de façon à la placer dans son état initialisé ainsi que des moyens de vérification de l'état initialisé de la cellule-mémoire de référence, ces moyens de vérification comportant ici une source de courant SC ainsi que l'amplificateur de lecture AMP.

Un premier interrupteur SW1, par exemple un transistor MOS, est connecté entre le générateur GEN3 et la cellule-mémoire de référence CELR.

Un deuxième interrupteur SW2, par exemple un transistor MOS, est connecté entre la cellule-mémoire CELR et la ligne de bits BLR.

Là encore, sur la figure 4, la référence RC désigne les résistances et capacités parasites des interconnexions.

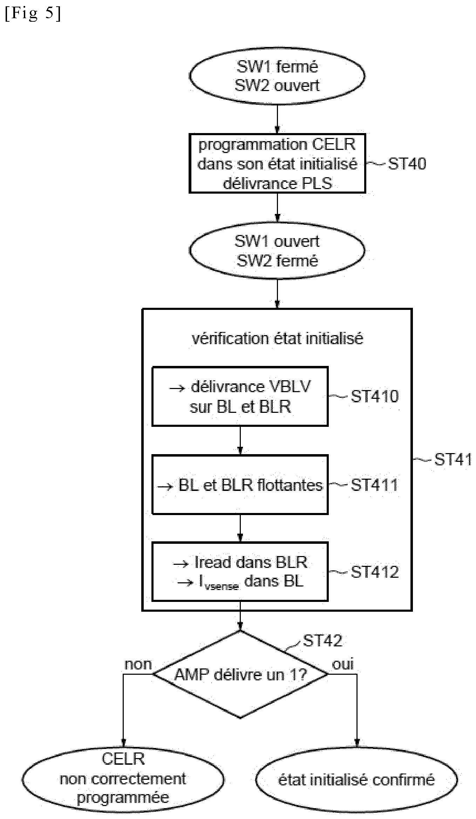

On se réfère maintenant plus particulièrement à la figure 5 pour décrire un rafraîchissement de la cellule-mémoire de référence CELR dans son état initialisé.

Dans un premier temps, l'interrupteur SW1 est fermé et l'interrupteur SW2 est ouvert. En conséquence, le générateur GEN3 est connecté à la cellule-mémoire de référence CELR et l'amplificateur de lecture AMP ne l'est pas.

Dans l'étape ST40, on procède à une programmation de la cellule-mémoire CELR de façon à la placer dans son état initialisé (SET).

A cet égard, on délivre l'impulsion PLS ayant une forme classique adaptée pour placer une cellule-mémoire du type PCM dans son état initialisé.

Puis, on ouvre l'interrupteur SW1 et on ferme l'interrupteur SW2 de façon à procéder dans l'étape ST41 à une vérification de l'état initialisé de la cellule-mémoire de référence CELR.

A cet égard, dans l'étape ST410, on délivre, par exemple à l'aide des générateurs GEN1 et GEN2 de la figure 2, ou bien à l'aide d'un autre unique générateur, une même tension VBLV sur les lignes de bits BL et BLR.

Cette tension VBLV est choisie de façon à émuler un courant de 16 microampères correspondant à l'état initialisé d'une cellule-mémoire.

Puis, on rend les lignes de bits BL et BLR flottantes (étape ST411).

La source de courant SC tire alors un courant Iᵥₛₑₙₛₑ dans la ligne de bits BL tandis que la cellule-mémoire de référence CELR tire un courant Iread dans la ligne de bits BLR (étape ST412).

Les deux courants sont comparés dans l'amplificateur de lecture AMP (étape ST42).

Si l'amplificateur AMP ne délivre pas un 1 logique, alors cela signifie que la cellule-mémoire CELR n'est pas correctement programmée.

Dans le cas contraire, l'état initialisé est confirmé.

Bien entendu, la source de courant SC peut être variable en fonction de la température.

Ceci peut être effectué en utilisant une source de courant du type proportionnel à la température absolue (PTAT) ou bien une source de courant pilotée par un capteur de température.

Généralement, le dispositif de mémoire comprend un plan mémoire comportant une matrice de cellules-mémoires CEL organisée en lignes et en colonnes.

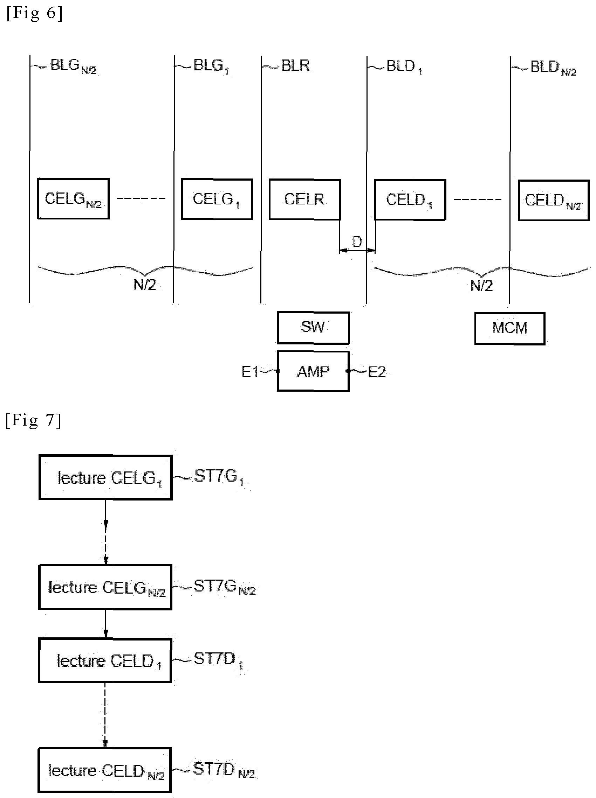

Ainsi, comme illustré sur la figure 6, une ligne de cellules-mémoires comporte des groupes de plusieurs cellules-mémoires.

A des fins de simplification la figure 6 illustre un seul groupe de plusieurs cellules-mémoires CELGᵢ et CELDᵢ respectivement couplées à la première entrée E1 de l'amplificateur de lecture AMP par l'intermédiaire d'interrupteurs commandables SW.

Une seule cellule-mémoire de référence CELR est associée à ce groupe de cellules-mémoires CEL.

Et cette cellule-mémoire de référence est connectée à la deuxième entrée E2 de l'amplificateur de lecture comme indiqué ci-avant.

Des moyens de commande MCM, par exemple un circuit logique, sont alors configurés pour sélectionner successivement lesdits interrupteurs SW de façon que les moyens de lecture puissent lire successivement chaque cellule-mémoire CEL comme expliqué ci-avant.

En pratique, on pourra choisir par exemple des groupes de N cellules-mémoires associés à une seule cellule-mémoire de référence CELR.

Et, de façon à ne pas trop éloigner les cellules-mémoires de ce groupe de la cellule-mémoire de référence, on choisira un nombre N de cellules-mémoires partitionné en deux sous-groupes de N/2 cellules-mémoires.

Et, comme illustré sur la figure 6, la cellule-mémoire de référence CELR est encadrée par un premier sous-groupe de N/2 cellules-mémoires CELG₁-CELG_{N/2} et par un deuxième groupe de N/2 cellules-mémoires CELD₁-CELD_{N/2}.

La distance D entre chaque cellule-mémoire CELG₁-CELD₁ immédiatement adjacente à la cellule-mémoire de référence est comme indiqué ci-avant préférentiellement de l'ordre de 10 à 20 microns.

Et, l'homme du métier choisira la valeur de N/2 de façon que les cellules-mémoires CELG_{N/2}-CELD_{N/2} les plus éloignées de la cellule de référence ne soient pas trop impactées par une distance trop importante vis-à-vis de la cellule-mémoire de référence CELR.

On pourra par exemple choisir sur chaque ligne du plan mémoire des groupes de 8 cellules-mémoires.

Chaque groupe est alors associé à une cellule de référence encadré à gauche et à droite par 4 cellules-mémoires.

Et, comme illustré sur la figure 7, dans une étape ST7G1 on lit d'abord la première cellule de gauche CELG₁ (étape ST7G₁) puis successivement les autres cellules de gauche jusqu'à lire la cellule CELG_{N/2} (étape ST7G_{N/2}).

Puis, on lit la première cellule de droite CELD₁ (étape ST7D₁) puis successivement les autres cellules de droite jusqu'à lire la cellule CELD_{N/2} dans l'étape ST7D_{N/2}.

Bien entendu tout autre ordre de lecture est possible.

## Revendications

1. Dispositif de mémoire du type à changement phase, comprenant une cellule-mémoire à changement de phase (CEL) configurée pour avoir un état initialisé ou un état réinitialisé correspondant respectivement à deux valeurs logiques d'une donnée stockée dans la cellule-mémoire et à deux valeurs de référence correspondantes de courants délivrés par la cellule-mémoire, et une cellule-mémoire de référence (CELR) à changement de phase placée dans un état initialisé, la cellule-mémoire de référence étant placée à côté de la cellule-mémoire et ayant une structure identique à celle de la cellule-mémoire, des moyens de lecture configurés pour lire la donnée stockée et comportant
- des premiers moyens (GEN1) configurés pour appliquer une première tension sur la cellule-mémoire et faire délivrer un premier courant (Iread) par la cellule-mémoire,
- des deuxièmes moyens (GEN2) configurés pour appliquer une deuxième tension sur la cellule-mémoire de référence et faire délivrer un deuxième courant (Iref) par la cellule-mémoire de référence dont la valeur est comprise entre lesdites deux valeurs de référence,
- un amplificateur de lecture (AMP) possédant une première entrée couplée à la cellule-mémoire et une deuxième entrée couplée à la cellule-mémoire de référence et configuré pour délivrer une information représentative de la valeur logique de la donnée en fonction des valeurs respectives du premier courant et du deuxième courant.

2. Dispositif selon la revendication 1, dans lequel la valeur du deuxième courant (Iref) est égale à la moitié de la différence entre les deux valeurs de référence.

3. Dispositif selon la revendication 1 ou 2, dans lequel la distance (D) entre la cellule-mémoire et la cellule-mémoire de référence est comprise entre 10 micromètres et 20 micromètres.

4. Dispositif selon l'une des revendications précédentes, comprenant en outre des moyens de rafraîchissement (GEN3, SC) configurés pour replacer régulièrement la cellule-mémoire de référence dans son état initialisé.

5. Dispositif selon la revendication 4, dans lequel les moyens de rafraîchissement comprennent un générateur de courant (GEN3) configuré pour délivrer une impulsion de courant à la cellule-mémoire de référence de façon à la placer dans son état initialisé et des moyens de vérification (SC, AMP) de l'état initialisé de la cellule mémoire de référence incluant l'amplificateur de lecture (AMP).

6. Dispositif selon l'une des revendications précédentes, comprenant plusieurs cellules-mémoires CELD₁, CELGᵢ) respectivement couplées à la première entrée de l'amplificateur de lecture (AMP) par l'intermédiaire d'interrupteurs commandables (SW), et des moyens de commande (MCM) configurés pour sélectionner successivement lesdits interrupteurs de façon que les moyens de lecture puissent lire successivement chaque cellule-mémoire.

7. Dispositif selon la revendication 6, comportant au moins un groupe de N cellules-mémoires, N étant un nombre pair, partitionné en deux sous-groupes de N/2 cellules-mémoires, et une cellule-mémoire de référence (CELR) par groupe encadrée par les deux sous-groupes de cellules-mémoires.

8. Procédé de lecture d'un dispositif de mémoire du type à changement phase, le dispositif comprenant une cellule-mémoire à changement de phase (CEL) configurée pour avoir un état initialisé ou un état réinitialisé correspondant respectivement à deux valeurs logiques d'une donnée stockée dans la cellule-mémoire et à deux valeurs de référence correspondantes de courants délivrés par la cellule-mémoire, procédé dans lequel
- on place une cellule-mémoire de référence à changement de phase (CELR) dans un état initialisé à côté de la cellule-mémoire et ayant une structure identique à celle de la cellule-mémoire,
- on applique une première tension (VBL1) sur la cellule-mémoire pour lui faire délivrer un premier courant,
- on applique une deuxième tension (VBL2) sur la cellule-mémoire de référence pour lui faire délivrer un deuxième courant dont la valeur est comprise entre lesdites deux valeurs de référence,
- on compare la valeur du premier courant et la valeur du deuxième courant et on délivre une information représentative de la valeur logique de la donnée en fonction des valeurs respectives du premier courant et du deuxième courant.

9. Procédé selon la revendication 8, dans lequel la valeur du deuxième courant (Iref) est égale à la moitié de la différence entre les deux valeurs de référence.

10. Procédé selon la revendication 8 ou 9, dans lequel on place la cellule-mémoire de référence à une distance (D) de la cellule-mémoire comprise entre 10 micromètres et 20 micromètres.

11. Procédé selon l'une des revendications 8 à 10, comprenant en outre un rafraîchissement régulier (ST40, ST41) de la cellule-mémoire de référence pour la replacer dans son état initialisé.

12. Procédé selon la revendication 11, dans lequel le rafraîchissement comprend une délivrance d'une impulsion de courant (PLS) à la cellule-mémoire de référence de façon à la placer dans son état initialisé et une vérification (ST41) de l'état initialisé de la cellule mémoire de référence.

13. Procédé selon l'une des revendications 8 à 11, dans lequel on associe une cellule-mémoire de référence (CELR) à plusieurs cellules-mémoires et on lit successivement chaque cellule-mémoire en utilisant la cellule-mémoire de référence.

14. Procédé selon la revendication 13, dans lequel on associe une cellule-mémoire de référence (CELR) à un groupe de N cellules-mémoires, N étant un nombre pair, partitionné en deux sous-groupes de N/2 cellules-mémoires, et on place la cellule-mémoire de référence entre les deux sous-groupes de cellules-mémoires.
